# EUROPÄISCHE PATENTSCHRIFT

(11) **EP 0 992 849 B1**
(45) Veröffentlichungstag und Bekanntmachung des Hinweises auf die Patenterteilung: **14.11.2001**
(21) Anmeldenummer: 99118427.6
(22) Anmeldetag: 17.09.1999
(51) Int. Cl.: G03F 7/033, B41C 1/10

(54) **Photopolymerisierbare Druckformen zur Herstellung von Reliefdruckplatten für den Druck mit UV-härtbaren Druckfarben**
Photopolymerizable printing forms for the production of relief printing plates suitable for printing with UV-curable printing inks
Blocs d'impression photopolymérisables pour la fabrication de planches d'impression en relief servant à l'impression avec des encres d'imprimerie durcissables aux UV

(30) Priorität: 09.10.1998 DE 19846529
(43) Veröffentlichungstag der Anmeldung: 12.04.2000
(73) Patentinhaber: BASF Drucksysteme GmbH, 70469 Stuttgart (DE)
(72) Erfinder: Telser, Thomas, Dr., 69469 Weinheim (DE); Knoll, Konrad, Dr., 67069 Ludwigshafen (DE); Philipp, Sabine, Dr., 64546 Mörfelden-Walldorf (DE)
(74) Vertreter: Karg, Jochen

(56) Entgegenhaltungen:
- EP-A- 0 675 412
- EP-A- 0 833 206
- DE-A- 19 615 533

## Beschreibung

Die vorliegende Erfindung betrifft ein photopolymerisierbares Gemisch mit einem Styrol-Styrol/Butadien-Styrol-Blockcopolymeren als Bindemittel sowie eine daraus hergestellte photopolymerisierbare Druckform. Sie betrifft weiterhin ein Verfahren zur Herstellung von Reliefdruckformen, insbesondere von Flexodruckplatten, sowie deren Verwendung zum Drucken mit UV-härtbaren Farben.

Photopolymerisierbare Druckformen sind prinzipiell bekannt und weisen im allgemeinen eine photopolymerisierbare Schicht auf, die ein polymeres Bindemittel, eine photopolymerisierbare Verbindung, einen Photopolymerisationsinitiator oder ein -initiatorsystem und gegebenenfalls weitere übliche Bestandteile enthält.

Für die Herstellung von Flexodruckplatten werden zumeist elastomere Bindemittel wie Block-Copolymere, zum Beispiel Dreiblock-Copolymere mit Styrol-Isopren-Styrol-Blöcken oder Styrol-Butadien-Styrol-Blöcken bevorzugt, wie sie zum Beispiel in der DE-A 22 15 090 beschrieben sind. Die Dreiblock-Copolymeren können als einzige Elastomere oder in Kombination mit Zweiblock-Copolymeren, zum Beispiel Styrol-Isopren- oder Styrol-Butadien-Zweiblock-Copolymeren, eingesetzt werden. Dreiblock-Copolymere aus Styrol-Isopren-Styrol/Butadien, bei denen der dritte Block statistisch aus Styrol- und Butadieneinheiten aufgebaut ist, werden in der EP-A 0 027 612 beschrieben.

Eine wichtige Eigenschaft von Druckplatten, insbesondere von Flexodruckplatten, die beachtet werden muss, ist die sogenannte Tonwertzunahme. Unter Tonwertzunahme versteht der Fachmann die Differenz zwischen dem Flächendeckungsgrad im Druck und dem Flächendeckungsgrad auf der Vorlage. Sie wird bestimmt, indem man die Rastertonwerte der Vorlage und des Druckes misst. Die Tonwertzunahme sollte idealerweise so gering wie möglich sein, um eine möglichst naturgetreue Wiedergabe der Vorlage im Druck zu erreichen. Außerdem sollte sie sich im Laufe des Druckprozesses, also mit zunehmender Auflage, möglichst nicht ändern.

Daher ist es von besonderer Bedeutung für gute Druckeigenschaften von photopolymeren Flexodruckplatten, dass sie nicht durch in der Druckfarbe enthaltene Komponenten oder Lösemittel angelöst oder angequollen werden. Anquellen der Druckplatte führt mit zunehmender Auflage zu abnehmender Härte der Druckplatte und zu einer unerwünschten Veränderung des Druckbildes. Die einzelnen Bildelemente der Platte verbreitern sich, die Tonwertübertragung nimmt zu und feine negative Bildelemente können zulaufen.

Photopolymere Flexodruckplatten sind nicht beständig gegen Ketone, Aromaten und Kohlenwasserstoffe. Zum Drucken werden daher üblicherweise Druckfarben auf Alkohol- und Wasserbasis mit einem Esteranteil von maximal 20 Gew. % eingesetzt (siehe z.B. Römpp Lexikon Lacke und Druckfarben, Georg Thieme Verlag, Stuttgart, New York 1998; S. 238/239).

In letzter Zeit werden daneben vermehrt durch UV-Licht härtbare Druckfarben eingesetzt, da sich hiermit eine bessere Druckqualität erreichen läßt und Belastungen der Umwelt durch Lösungsmitteldämpfe vermieden werden. Es werden dabei sowohl radikalisch vernetzbare wie auch kationisch vernetzbare Druckfarben eingesetzt. Die erwähnten Druckplatten mit besagten Block-Copolymeren sind für den Einsatz mit UV-härtenden Druckfarben jedoch weniger gut geeignet, da die in den Farben enthaltenen Monomere die Druckplatten anquellen.

Es ist daher von EP-A 833 206 und EP-A 833 207 vorgeschlagen worden, zur Verbesserung der Beständigkeit von Flexodruckplatten gegen UV-härtbare Farben spezielle Blockcopolymere mit Polymerblöcken aus Styrol- und Isopren/Butadien-Einheiten einzusetzen. Die eingesetzten Bindemittel weisen aber relativ hohe Dien-Anteile auf, neigen dementsprechend zu Klebrigkeit und sind thermisch sehr empfindlich. Dies kann zu Stippen im Zuge der Herstellung der Druckplatte führen, welche die optischen Eigenschaften der Druckplatte nachteilig beeinflussen. Für ein gutes Belichtungsergebnis und damit ein gutes Druckergebnis ist es aber notwendig, dass die photopolymerisierbare Druckplatte optisch sehr homogen ist, und keine das Licht stärker streuenden Inhomogenitäten in der photopolymerisierbaren Schicht vorhanden sind. Außerdem weisen die vorgeschlagenen Bindemittel relativ hohe Vinylbindungsanteile von bis zu 70 % auf, wodurch es nachteiligerweise zu unerwünschten Reaktionen des Bindemittels mit polymerisierbaren Bestandteilen der UV-härtbaren Druckfarben kommen kann.

Aufgabe der vorliegenden Erfindung war es, photopolymerisierbare Gemische und Druckformen für die Herstellung von Relief-, insbesondere Flexodruckplatten, bereitzustellen, die eine verbesserte Quellbeständigkeit gegenüber UV-härtbaren Druckfarben, eine verringerte Tonwertzunahme, eine verringerte Neigung zur Reaktion mit polymerisierbaren Bestandteilen von UV-härtbaren Druckfarben aufweisen, und die zugleich das Auflösungsvermögen der besten gegenwärtig bekannten Flexodruckplatten auf Basis von Bindemitteln aus Styrol-Isopren-Styrol - oder Styrol-Butadien-Styrol-Dreiblock-Copolymeren erreichen.

Dementsprechend wurde ein photopolymerisierbares Gemisch gefunden, das
(a) ein elastomeres Block-Copolymeres A als Bindemittel,
(b) eine polymerisierbare Verbindung M und
(c) eine Verbindung C enthält, die unter Einwirkung aktinischer Strahlung die Polymerisation der Verbindung M zu initiieren vermag.

Das erfindungsgemäße Gemisch ist dadurch gekennzeichnet, dass das elastomere Block-Copolymere aus
- einem Block (S) aus Styrol,
- einem statistischen Block (S/B) aus Styrol und Butadien und
- einem Block (s) aus Styrol besteht,
wobei die Glasübergangstemperatur T_{g} der Blöcke S über 25°C und die des Blockes S/B unter 25°C liegt und das Phasenvolumenverhältnis der Blöcke S zu Block S/B so gewählt ist, dass der Anteil der Hartphase S am gesamten Blockcopolymerisat 1 bis 40 Vol. % und der Gewichtsanteil des Butadiens weniger als 50 Gew. % beträgt.

Erfindungsgemäß wurde weiterhin eine photopolymerisierbare Druckform mit einem dimensionsstabilen Schichtträger und einer darauf aufgebrachten photopolymerisierbaren Schicht gefunden, die aus einem Gemisch der oben angegebenen Zusammensetzung besteht.

Überraschenderweise wurde gefunden, dass sich die erfindungsgemäße photopolymerisierbare Druckform hervorragend zur Herstellung von Relief-, insbesondere von Flexodruckplatten, mit guter Beständigkeit gegenüber UV-härtbaren Druckfarben eignet.

Das erfindungsgemäße photopolymerisierbare Gemisch enthält ein elastomeres Dreiblockcopolymeres mit einem Styrol/Butadien-Block (S/B) in der Mitte als Weichphase und je einem Styrol-Block (S) an den Enden als Hartphase. Der Styrol/Butadien-Block ist statistisch aus Styrol- und Butadien-Monomeren aufgebaut. Die Glastemperatur der Blöcke S ist größer als 25°C und die des Blockes S/B kleiner als 25°C. Das Phasenvolumenverhältnis der Blöcke S zu Block S/B wird so gewählt, dass der Anteil der Hartphase S am gesamten Blockcopolymerisat 1 bis 40 Vol% und der Gewichtsanteil des Butadiens im gesamten Blockcopolymer weniger als 50 Gew. % beträgt. Bevorzugt betragt der Gewichtsanteil des Butadiens 25 bis 50 Gew.% und besonders bevorzugt 25 bis 40 Gew.%. Der Vinylgruppenanteil des Blockcopolymeren sollte möglichst gering sein. Bevorzugt beträgt der relative Anteil an 1,2-Verknüpfungen des Butadiens in der Polymerkette, bezogen auf die Summe an 1,2- und 1,4-cis/trans-Verknüpfungen, weniger als 15%. Es ist besonders bevorzugt, dass der Anteil an 1,2-Verknüpfungen kleiner als 12% ist.

Der Styrol/Butadien-Block (S/B) hat bevorzugt einen Butadienanteil zwischen 35 und 70 Gew. % und einen Styrolanteil zwischen 65 und 30 Gew.-% bezüglich des Summe der Bestandteile des Blocks.

Die Herstellung derartiger Bindemittel ist bekannt und beispielsweise in WO 97/40079 und in WO 95/35335 beschrieben.

Bevorzugt wird das Styrol-Butadien/Styrol-Styrol-Blockcopolymere als einziges Bindemittel eingesetzt. Die Erfindung umfasst aber auch solche photopolymerisierbaren Gemische, die noch andere thermoplastisch elastomere Blockcopolymere als Bindemittel enthalten. Geeignet sind insbesondere solche mit Polystyrolendgruppen. Die Menge der erfindungswesentlichen Polymere sollte aber 80 Gew. % bzgl. der Menge aller polymeren Bindemittel nicht unterschreiten.

Die erfindungsgemäßen Gemische enthalten weiterhin in bekannter Weise polymerisierbare Verbindungen, beziehungsweise Monomere M. Die Monomeren sollen mit dem Bindemittel verträglich sein und mindestens eine polymerisierbare ethylenische Doppelbindung aufweisen. Geeignete Monomere haben im allgemeinen einen Siedepunkt von mehr als 100°C bei Atmosphärendruck und ein Molekulargewicht bis zu 3000 g/mol, vorzugsweise bis zu 2000 g/mol. Als besonders vorteilhaft haben sich Ester oder Amide der Acryl- oder Methacrylsäure, Styrol oder substituierte Styrole, Ester der Fumar- oder Maleinsäure oder Allylverbindungen erwiesen. Geeignete Monomere sind in der EP-A 326 977, Seite 5 genannt.

Als Initiatoren C für die Photopolymerisation sind unter anderem Benzoin oder Benzoinderivate, wie α-Methylbenzoin oder Benzoinether, Benzilderivate, wie Benzilketale, Acylarylphosphinoxide, Acylarylphosphinsäureester oder -natriumsalze, Mehrkernchinone 5 oder Benzophenone geeignet.

Die photopolymerisierbaren Gemische enthalten in der Regel 50 bis 95 Gew. % des Bindemittels bzgl. der Summe aller Bestandteile. Vorzugsweise werden 70 bis 95 Gew. % des Bindemittels eingesetzt. Die Menge der polymerisierbaren Monomeren M liegt im Bereich von 4,9 bis 45 Gew.% , bevorzugt zwischen 4,9 und 30 Gew. %. Die Menge an Photoinitiator beträgt 0,1 bis 5 Gew.%.

Die erfindungsgemäßen Gemische können darüber hinaus Weichmacher enthalten. Beispiele für geeignete Weichmacher sind modifizierte und unmodifizierte Naturöle und -harze, Alkyl-, Alkenyl-, Arylalkyl- oder Arylalkenylester von Säuren, wie Alkansäuren, Arylcarbonsäuren oder Phosphorsäure; synthetische Oligomere oder Harze wie Oligostyrol, oligomere Styrol-Butadien-Copolymere, oligomere α-Methylstyrol/p-Methylstyrol-Copolymere, flüssige Oligobutadiene, oder flüssige oligomere Acrylnitril-Butadien-Copolymere; sowie Polyterpene, Polyacrylate, Polyester oder Polyurethane, Polyethylen, Ethylen-Propylen-Dien-Kautschuke oder α-Methyl-Oligo(ethylenoxid). Beispiele besonders gut geeigneter Weichmacher sind paraffinische Mineralöle; Ester von Dicarbonsäuren wie Dioctyladipat oder Terephthalsäuredioctylester; naphthenische Weichmacher oder Polybutadiene mit einem Molgewicht zwischen 500 und 5000 g/mol. Es können auch Gemische verschiedener Weichmacher eingesetzt werden. Die Menge des gegebenenfalls enthaltenen Weichmachers wird vom Fachmann entsprechend der gewünschten Härte der Druckplatte gewählt. Sie liegt in der Regel unter 40 Gew.% bzgl. der Summe aller Bestandteile des photopolymerisierbaren Gemischs.

Die erfindungsgemäßen Gemische können ferner übliche Hilfsstoffe enthalten, vor allem Inhibitoren für die thermisch initiierte Polymerisation, Farbstoffe, Pigmente, photochrome Zusätze, Mittel zur Verbesserung der Reliefstruktur, Vernetzungshilfsmittel, Antioxidantien, Antiozonantien, Füllstoffe, Flußmittel oder Formtrennmittel. Ihre Menge liegt im allgemeinen unter 20 Gew.% bzgl. der Summe aller Bestandteile des photopolymerisierbaren Gemischs und wird vorteilhaft so gewählt, dass die Gesamtmenge aus Weichmacher und Hilfmitteln 50 Gew.% bzgl. der Summe aller Bestandteile nicht übersteigt.

Beispiele für Inhibitoren für die thermisch initiierte Polymerisation sind Hydrochinon, p-Methoxyphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine.

Farbstoffe, Pigmente oder photochrome Zusätze können zugesetzt werden und dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist es, daß sie - ebenso wie die Inhibitoren - die Photopolymerisation der Gemische nicht stören.

Beispiele für Vernetzungshilfsmittel sind tri- und tetrafunktionelle Thiolverbindungen.

Beispiele für Antioxidanten sind sterisch gehinderte Monophenole, wie 2,6-Di-tert.-butyl-p-kresol; alkylierte Thiobis- und Alkylidenbisphenole; Hydroxybenzyle, wie 1,3,5-Trimethyl-2,4,6-tris-(3,5-di-tert.-butyl-4-hydroxybenzyl)benzol; Triazine; Zinkbutyldithiocarbamat; Dilaurylthiodipropionat; oder Phosphite, wie Tris(nonylphenyl)phosphit.

Ein Beispiel für ein Flußmittel ist Calciumstearat. Ein Beispiel für ein Formtrennmittel ist Talkum.

Beispiele für Antiozonantien sind die üblichen und bekannten Ozonschutzwachse sowie die Chloralkane mit 8 bis 40 Kohlenstoffatomen und 30 bis 73 Gew.-% Chlor im Molekül.

Beispiele für Mittel zur Verbesserung der Reliefstruktur der aus den erfindungsgemäßen Aufzeichnungsmaterialien hergestellten Reliefdruckplatten sind beispielsweise 9,9'-Dianthronyl und 10,10'-Bisanthron.

Die strahlungsempfindliche Schicht wird bei der erfindungsgemäßen photopolymerisierbaren Druckform gegebenenfalls mit einer Haftschicht auf einen dimensionsstabilen Träger aufgebracht. Beispiele geeigneter dimensionsstabiler Träger sind Platten, Folien sowie konische und zylindrische Röhren (sleeves) aus Metallen wie Stahl, Aluminium, Kupfer oder Nickel oder aus Kunststoffen wie Polyethylenterephthalat (PET), Polybutylenterephthalat, Polyamid, Polycarbonat, gegebenenfalls auch Gewebe und Vliese, wie Glasfasergewebe sowie Verbundmaterialien aus Glasfasern und Kunststoffen. Als dimensionsstabile Träger kommen insbesondere dimensionsstabile Trägerfolien, beispielsweise Polyethylen- oder Polyesterfolien, insbesondere Polyethylenterephthalatfolien in Frage. Diese Trägerfolien sind im allgemeinenen zwischen 50 und 500 µm, vorzugsweise 75 bis 400 µm, beispielsweise ca. 125 µm dick. Der Schichtträger kann mit einer weichelastischen Unterschicht unterlegt sein.

Als Haftschichten können unter anderem Polyurethanhaftlacke, z.B. gemäß DE-A-30 45 516 auf Basis von polyisocyanatvernetzenden Polyether- oder Polyesterlacken in Schichtdicken zwischen 0,5 und 50, inbesondere zwischen 2 und 30 µm dienen.

Die Dicke der photopolymerisierbaren reliefbildenden Schicht richtet sich in erster Linie nach dem Verwendungszweck der erfindungsgemäßen photopolymerisierbaren Druckformen, weil die erfindungsgemäßen Aufzeichnungsmaterialien für verschiedene Drucktechniken geeignet sind. So variiert die Dicke im allgemeinen von 0,001 bis 7 mm, vorzugsweise 0,1 bis 7 mm und insbesondere 0,7 bis 6,5 mm. Sie wird vom Fachmann gemäß den Anforderungen der jeweils gewünschten Anwendung gewählt.

Die photopolymerisierbare Schicht kann auch aus photopolymerisierbaren Teilschichten aufgebaut werden. Diese Teilschichten können von gleicher, in etwa gleicher oder von unterschiedlicher stofflicher Zusammensetzung sein. Die Herstellung der aus Teilschichten aufgebauten Schicht kann nach der in der EP-A 0 084 851 angegebenen Methode erfolgen.

Außerdem kann das erfindungsgemäße Aufzeichnungsmaterial eine lichtdurchlässige, in den Entwicklern für die Photopolymerschicht lösliche oder quellbare, glatte oder mattierte, nicht klebrige Deckschicht enthalten, welche an der Photopolymerschicht fester haftet als an einer gegebenenfalls vorhandenen Schutzfolie und welche von einem reissfeste Filme bildenden Polymeren und den gegebenenfalls darin enthaltenen Zusatzstoffen gebildet wird. Beispiele geeigneter, reissfester Filme bildender Polymerer sind Polyamide, voll- oder teilverseifte Polyvinylacetate oder Polyethylenoxid/Vinylacetat-Pfropfpolymerisate, Copolyamide, Polyurethane, Poly(meth)acrylate, Polyvinyl-alkohol-alkancarbonsäureester eines Hydrolysegrades von 30 bis 99%, Cyclokautschuke hohen Cyclisierungsgrads, Ethylen/Propylen-Copolymerisate, Homo- und Copolymerisate des Vinylchlorids oder Ethylen/Vinylacetat-Copolymerisate. Beispiele geeigneter Deckschichten, welche Zusatzstoffe enthalten, sind aus der DE-A 28 23 300 oder der DE-B 21 23 702 bekannt. Im allgemeinen sind die Deckschichten 0,2 bis 25 µm dick.

In einer besonderen Ausführungsform der Erfindung befindet sich auf der Deckschicht oder vorzugsweise direkt auf der photopolymerisierbaren Schicht eine gegen IR-Stahlung empfindliche Schicht. Die IR-empfindliche Schicht ist IR-ablativ, d.h. sie kann durch Bestrahlung mit einem IR-Laser, vorzugsweise einem Nd/ YAG-Laser, teilweise abgetragen, d.h. bildmäßig beschrieben werden, wie beispielsweise in der EP-A 767 407 beschrieben.

Die gegen IR-Strahlung empfindliche Schicht ist im Entwickler löslich oder dispergierbar und enthält in einem filmbildenden Bindemittel mit elastomeren Eigenschaften mindestens eine feinverteilte Substanz, die eine hohe Absorption im Wellenlängenbereich zwischen 750 und 20000 nm und im aktinischen Bereich eine optische Dichte grösser 2,5 aufweist. Es kann sich dabei um Entwickler auf Wasser- bzw. Wasser/Alkohol-Basis handeln oder auf Basis von organischen Lösungsmitteln. Als Bindemittel eignen sich für die IR-empfindliche Schicht Polymerisate, insbesondere Copolymerisate, die wasser- bzw. alkohollöslich oder -dispergierbar sind, oder solche, die in organischen Lösungsmitteln oder Lösungsmittelgemischen löslich oder dispergierbar sind.

Beispiele für in Wasser bzw. Wasser/Alkohol-Gemischen lösliche oder dispergierbare Bindemittel mit elastomeren Eigenschaften sind Polyvinylalkohol/Polyethylenglykol- Copolymere (z.B. Mowiol® GE 5-97 der Fa. Hoechst), die durch Propfen von Vinylacetat auf Polyethylenglykol mit Molekulargewichten zwischen 1000 und 50 000 und anschließender Verseifung bis zu einem Verseifungsgrad zwischen 80 und 100% erhältlich sind.

Beispiel für in organischen Lösungsmitteln oder -gemischen lösliche oder dispergierbare Bindemittel mit elastomeren Eigenschaften sind thermoplastisch-elastomere Polyamid-Harze, die kommerziell erhältlich sind (bspw. Macromelt® , Fa. Henkel). Die genannten Produkte sind in den jeweiligen Firmenschriften ausführlich beschrieben.

Beispiele für die im filmbindenden Bindemittel der IR-empfindlichen Schicht enthaltenen feinverteilten Substanzen sind verschiedene feinteilige Rußarten, z.B. Farbruß FW 2000, Spezialschwarz 5 oder Printex® U der Fa. Degussa mit einer mittleren Primärteilchengröße von 13 bis 30 nm. Vorteilhafterweise verwendet man Lösungen des Bindemittels, in denen die Substanzen mit hoher IR-Absorption homogen dispergiert sind. Diese Lösung wird entweder direkt auf die lichtempfindliche Schicht gleichmäßig aufgetragen und getrocknet oder auf eine Folie gegossen, getrocknet und auf die lichtempfindliche Schicht aufkaschiert.

Die photopolymerisierbare Druckform kann gegen mechanische Beschädigungen durch eine Schutzfolie geschützt werden, die sich entweder auf der photopolymerisierbaren Schicht, auf der Deckschicht oder der IR-ablativen Schicht befindet (vgl. z.B. Ullmanns Encyclopedia of Industrial Chemistry, Band A 13, Seite 629).

Die besonderen Vorteile der erfindungsgemäßen photopolymerisierbaren Druckformen treten bei ihrer Verwendung für die Herstellung von Reliefdruckplatten, insbesondere von Flexodruckplatten, in überzeugender Weise zu Tage. Je nach Aufbau der photopolymerisierbaren Druckform kommen zwei Herstellverfahren in Betracht. Umfasst die photopolymerisierbare Druckform keine IR-empfindliche Schicht, so wird die Struktur der Reliefdruckplatte durch Auflegen einer Bildmaske oder Negativvorlage gefolgt von anschließender Belichtung mit aktinischer Strahlung erzeugt. Umfasst die photopolymerisierbare Druckform eine IR-empfindliche Schicht, so entfällt das Auflegen einer Bildmaske, sondern statt dessen wird die IR-empfindliche Schicht mit einem IR-Laser bildmäßig strukturiert, und so eine Maske auf der darunterliegenden photopolymerisierbaren Schicht erzeugt. Anschließend kann in bekannter Art und Weise durch die erzeugte Maske mit aktinischem Licht belichtet werden.

Bei Belichtung mit Hilfe einer aufgelegten Negativvorlage oder Bildmaske umfasst die Herstellung der Reliefdruckplatten aus den erfindungsgemäßen photopolymerisierbaren Druckformen üblicherweise die folgenden Arbeitsgänge:
a) gegebenenfalls Vorbehandeln der erfindungsgemäßen Aufzeichnungsmaterialien,
b) Ablösen der Deckfolie falls vorhanden,
c) Auflegen einer Bildmaske oder Negativvorlage,
d) bildmäßiges Belichten der photopolymerisierbaren Schicht mit aktinischem Licht einer Wellenlänge zwischen 230 und 450, insbesondere 350 und 450 nm,
e) Auswaschen (Entwickeln) der unbelichteten Bereiche der bildmäßig belichteten Schicht mittels geeigneter Entwickler, wobei auch die gegebenenfalls vorhandene Deckschicht weggewaschen wird,
f) Trocknen
g) gegebenenfalls Nachbehandeln der in dieser Weise erhaltenen Reliefdruckplatten, welche nun die Reliefschicht enthalten, oder aus dieser bestehen.

Die Dicke der Reliefschicht variiert je nach Anwendungszweck der Reliefdruckplatten von 0,1 bis 7, insbesondere 0,7 bis 6,5 mm.

Eine übliche Methode der Vorbehandlung ist die vollflächige Belichtung des Aufzeichnungsmaterials von der Rückseite her mit aktinischem Licht. Unter Rückseite ist hier diese Seite zu verstehen, welche der später gebildeten Reliefschicht abgewandt ist.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierte Lampen oder Kohlenbogenlampen.

Beispiele geeigneter Entwickler sind aliphatische oder aromatische Kohlenwasserstoffe, wie n-Hexan, n-Heptan, Octan, Petrolether, Ligroin, Limonen oder andere Terpene, Toluol, Xylol, Ethylbenzol oder Isopropylbenzol oder Gemische aus diesen Lösemitteln; Ketone, wie Aceton oder Methylethylketon; Ether, wie Di-n-butylether; Ester, wie Essigsäureethylester, halogenierte aliphatische Kohlenwasserstoffe, wie Methylenchlorid, Chloroform, Trichlorethane, Tetrachlorethylen, Dichlortetrafluorethane oder Trichlortrifluorethane; oder Gemische, die zwei oder mehr dieser Lösemittel enthalten; oder Gemische die eines oder mehrere dieser Lösemittel und zusätzlich noch Alkohole, wie Methanol, Ethanol, Isopropanol oder n-Butanol enthalten; oder Lösemittel und Gemische der genannten Art, die zusätzlich feste, flüssige oder gasförmige organische und anorganische Verbindungen, wie etwa Tenside, in untergeordneten Mengen enthalten.

Übliche Methoden der Nachbehandlung der Reliefbilder oder Druckformen sind das vollflächige Nachbelichten mit aktinischem Licht einer Wellenlänge zwischen 150 und 450 nm oder das Behandeln mit halogenhaltigen, insbesondere bromhaltigen Lösungen.

Im Falle einer photopolymerisierbaren Druckplatte mit IR-empfindlicher Schicht umfasst die Herstellung der Reliefdruckplatten aus den erfindungsgemäßen photopolymerisierbaren Druckformen üblicherweise die folgenden Arbeitsgänge:
(a) Ablösen der Deckfolie falls vorhanden,
(b) bildmäßiges Beschreiben der IR-empfindlichen Schicht mit einem IR-Laser,
(c) gegebenenfalls Vorbehandeln der erfindungsgemäßen Aufzeichnungsmaterialien,
d) bildmäßiges Belichten der photopolymerisierbaren Schicht mit aktinischem Licht einer Wellenlänge zwischen 230 und 450, insbesondere 350 und 450 nm,
e) Auswaschen (Entwickeln) der unbelichteten Bereiche der bildmäßig belichteten Schicht mittels geeigneter Entwickler, wobei auch die Reste der IR-empfindlichen Schicht sowie die gegebenenfalls vorhandene Deckschicht weggewaschen wird,
f) Trocknen
g) gegebenenfalls Nachbehandeln der in dieser Weise erhaltenen Reliefdruckplatten, welche nun die Reliefschicht enthalten, oder aus dieser bestehen.

Die bildmäßige Beschreibung der IR-empfindlichen Schicht mit einem IR-Laser kann zweckmäßigerweise auf einer Trommel erfolgen, auf der die Platte montiert ist. Als Vorteil erweist sich hier der elastomere Charakter der IR-empfindlichen Schicht, durch den die Oberfläche der Platte, die durch die Montage auf die Trommel gespannt wird, nicht beschädigt wird, wie es bei einer nicht-elastomeren Schicht der Fall wäre.

Es ist auch möglich, die Reste einer wasser- oder alkohollöslichen IR-empfindlichen Schicht zunächst mit einem Entwickler auf Wasser- bzw. Wasser/Alkoholbasis zu abzulösen und anschließend die Entwicklung der bildmäßig belichteten Schicht mit einem organischen Entwickler durchzuführen. Vorteilhaft wird hierbei der organische Entwickler nicht mit stark färbenden Feststoffen wie bspw. Ruß verunreinigt.

Werden die erfindungsgemäßen Aufzeichnungsmaterialien dem jeweils entsprechenden Verfahren unterzogen, erweisen sie sich als
- rasch belichtbar, wobei ihr Belichtungsspielraum ausgesprochen groß ist,
- detailgetreu in der Wiedergabe auch der feinsten und daher kritischen Bildmotive der Bildmasken oder Negativvorlagen und als
- ausgesprochen auswaschstabil, so daß die Entwicklungsbedingungen zwecks Verkürzung der Entwicklungszeiten bedenkenlos verschärft werden können.

Die aus den erfindungsgemäßen Aufzeichnungsmaterialien erhaltenen Druckplatten zeigen während des Druckens auf einem üblichen und bekannten Flexodruckwerk eine ausgeprägte Stabilität gegenüber UV-härtbaren Druckfarben. Die Quellbarkeit mit den Bestandteilen der Druckfarbe ist gegenüber Druckplatten mit konventionellen Dreiblockcopolymeren deutlich herabgesetzt. Ein besonders überraschender Vorteil der erfindungsgemäßen Druckplatten liegt in den deulich verbesserten Druckeigenschaften mit UV-härtenden Druckfarben. Gegenüber Druckplatten, die konventionelle Dreiblockcopolymere enthalten, ist die Tonwertzunahme deutlich verringert, wie sich aus der Druckkennlinie der Platten ergibt. Darüber hinaus können die neuen Flexodruckplatten mehrfach wiederverwendet werden, ohne daß die Qualität der Druckerzeugnisse hierbei leidet.

Die folgenden Beispiele sollen die vorliegende Erfindung erläutern, ohne dass dadurch der Umfang der Erfindung eingeschränkt wird.

Die beschriebenen Messwerte wurden in folgender Art und Weise ermittelt.

| Härte nach Shore A | nach DIN 53505, 6 mm Schicht |
|---|---|
| 24h-Quellwert | Eine Vollfläche des Klischees mit den Abmessungen 5 x 5 cm wurde mit Druckfarbe bestrichen. Nach einer Einwirkzeit von 24 Stunden wurde die Druckfarbe abgewischt und die Gewichtszunahme bestimmt. |
| Tonwertzunahme | Die Tonwerte des Films und der Drucke wurden densiometrisch gemessen, indem die gedeckte Fläche von definierten Feldern im Film und im Druck gemessen wurde. Aus jeweils 5 Einzelmessungen wurde ein Mittelwert gebildet. |

Für die Belichtungsversuche wurde eine Testform mit den folgenden Bildelementen eingesetzt: Pro Skalenfarbe zwei 10-stufige Rasterstufenkeile mit optisch gleichabständigen Tonwertbereichen, jeweils in 48 Linien/cm bzw. 60 Linien/cm; zwei Bildmotive in Rasterweite 60 Linien /cm; 3 Rasterverläufe parallel und senkrecht zur Druckrichtung (Verlaufstonwerte 80 - 1 %); Vollflächenfelder; Kontrollfelder zur Druckbeistellung; Linienfelder in 0°, 45° und 90° Winkelung; Kopierkontrollfelder mit 1, 2 und 3 % Flächendeckung und Negativelementen und Liniengitter (positiv und negativ, breite der Linien 55µm) ; Druckkontrollstreifen aus Rasterfeldern in den Abstufungen 5, 10, 30, 50, 70 und 100%. Die Volltondichte betrug 1,05.

### Beispiel 1: Herstellung des Styrol-Styrol/Butadien-Styrol-Blockcopolymeren

Ein Styrol-Styrol/Butadien-Styrol-Blockcopolymeres mit einem statistischen Styrol/Butadien-Block -Block (Styroflex® ) wurde gemäss WO 97/40079 hergestellt, jedoch mit anderen Einsatzstoffmengen. Es wurde ein Styrol-Styrol/Butadien-Styrol-Blockcopolymeres mit 32% Styrol und 68% statistischen Styrol/Butadien-Einheiten erhalten. Tabelle 1 zeigt die Einsatzstoffmengen und Eigenschaften des erhaltenen Blockcopolymeren.

| Bedeutung der Abkürzungen sowie Messmethoden: | |
|---|---|
| T_{A}/T_{E} | Anfangstemperatur/Endtemperatur jeder Polymerisationsstufe |
| K-Salz | Kalium-3,7-Dimethyl-3-oktanoat |
| Zahlenmittel Mₙ und Gewichsmittel M_{w} des Molekulargewichtes | mittels GPC und Polystyrol-Standarts |
| T_{g1} und T_{g2} | Glasübergangstemperatur des Weichblocks bzw. des Hartblocks |

| Herstellbedingungen | |
|---|---|
| s-BuLi | 87,3 mmol |
| Styrol 1 | 1638 g |
| T_{A}/T_{E} | 40/68°C |
| K-Salz | 2,36 mmol |
| Li:K-Verhältnis | 37:1 |
| Butadien 1 | 1250 g |
| Styrol 2 | 1126 g |
| T_{A}/T_{E} | 52/74°C |
| Butadien 2 | 1250 g |
| Styrol 3 | 1126 g |
| T_{A}/T_{E} | 54/75°C |
| Butadien 3 | 1250 g |
| Styrol 4 | 1126 g |
| T_{A}/T_{E} | 56/75°C |
| Styrol 5 | 1638 g |
| T_{A}/T_{E} | 70/80°C |

**Tabelle 1:**

| Herstellbedingungen und Eigenschaften des Styrol-Butadien/Styrol-Styrol-Blockcopolymeren mit statistischem Butadien/Styrol-Block. | |
|---|---|
| Polymereigenschaften | |
| Mₙ | 136 000 g/mol |
| M_{w} | 163 000 g/mol |
| T_{g1} | - 55 bis - 25°C |
| T_{g2} | 60 bis 100°C |

### Beispiel 2

Eine Lösung aus
78 Gewichtsteilen des in Beispiel 1 hergestellten Styrol-Styrol/ Butadien-Styrol-Blockcopolymeren mit 32% Styrol und 68% Styrol/ Butadien-Einheiten (Styroflex® , BASF),
10 Gewichtsteilen Hexandioldiacrylat,
5 Gewichtsteilen Paraffinöl (Weißöl S 5000),
1 Gewichtsteil Benzildimethylketal,
1 Gewichtsteil Di-t-butyl-p-kresol
und 150 Gewichtsteilen Toluol
wurde durch Rühren bei 80°C hergestellt. Die Lösung wurde auf eine 125 µm dicke Polyethylenterephthalatfolie (Mylar® , Du Pont de Nemours Co.) gegossen. Die Folie wurde zuvor mit einer ca. 5 µm dünnen Deckschicht aus Polyamid (Makromelt® 6900, Henkel KGa.A.) beschichtet. Die Lösung wurde bei 80°C auf die Folie aufgegossen und anschließend 2 h bei 60°C getrocknet. Anschließend wurde die Schicht über Nacht abgelüftet. Nach Trocknen und Ablüften betrug die Dicke der lichtempfindlichen Schicht 700 µm. Der Verbund aus Deckfolie, Deckschicht und lichtempfindlicher Schicht wurde anschließend durch Kaschieren mit einer mit Haftlack versehenen 125 µm dicken Trägerfolie aus Polyethylenterephthalat (Hostaphan® RN) verbunden.

Nach einer Lagerzeit von 1 Woche wurde aus der photopolymerisierbaren Druckplatte ein Klischee hergestellt. Folgende Verarbeitungsschritte wurden durchgeführt:
a) Abziehen der Schutzfolie,
b) Auflegen eines Testfilms (Beschreibung siehe oben),
c) stufenweise bildmäßige Hauptbelichtung unter Vakuumfolie (F III Belichter BASF,
   Belichtungszeiten von 2 bis 20 Minuten),
d) Auswaschen der Platte bis auf die Trägerfolie (Durchlaufsystem VF III BASF,
   Durchlaufzeit 30 mm/min, Auswaschmittel nylosolv® II von BASF, 30°C, Relieftiefe 700 um) ,
e) 2 h Trocknen bei 65°C
f) Nachbelichtung (F III Belichter BASF, 10 Minuten)
g) Nachbehandeln mit UV-C-Licht (F III Nachbehandlungsgerät BASF, 10 Minuten)

Das hergestellte Klischee wurde beurteilt. Bestimmt wurde die Belichtungszeit, die notwendig ist, um die Testelemente korrekt auszubilden. Ferner wurde die Shore-A-Härte des Klischeematerials bestimmt. An den Vollflächen des Klischees wurden Quellungsmessungen vorgenommen. Als Druckfarben wurden eine durch UV-Belichtung nach einem radikalischen Mechanismus härtbare Druckfarbe (Magenta Y 1635 C, Zeller-Gmelin) und eine durch UV-Belichtung nach einem kationischen Mechanismus härtbare Druckfarbe (Magenta Q 1635 C, Zeller-Gmelin) verwendet. Die Ergebnisse sind in Tabelle 2 zusammengestellt.

Weiterhin wurde ein Druckversuch mit der kationisch härtenden Druckfarbe durchgeführt. Hierzu wurde die Druckplatten auf einen Druckzylinder aufgespannt und auf einem üblichen Flexodruckwerk (Druckmaschine: Nilpeter-F 2400) verdruckt. Der Bedruckstoff waren Polyethylenfolie (F) und Karton (K). Die Druckgeschwindigkeit betrug 30 m/min. Die Weite des Rasters betrug 54 Linien/cm. Gemessen wurde die Tonwertzunahme des Druckes nach einer Zeit von 240 min. Die Ergebnisse des Druckversuches sind in Tabelle 2 zusammengestellt.

### Beispiel 3

Eine photopolymerisierbare Druckplatte wurde entsprechend Beispiel 2 hergestellt, aber die Bestandteile der Ausgangslösung waren:
68 Gewichtsteile des in Beispiel 1 angegebenen Blockcopolymeren,
10 Gewichtsteile Hexandioldiacrylat,
10 Gewichtsteile Dihydrodicyclopentadienylacrylat,
5 Gewichtsteile Palatinol® AH
1 Gewichtsteil Benzildimethylketal und
1 Gewichtsteil Di-t-butyl-p-kresol in
150 Gewichtsteilen Toluol

Die Druckplatte wurde wie in Beispiel 1 zum Klischee verarbeitet und beurteilt. Die Ergebnisse finden sich in Tabelle 2 und 3.

### Vergleichsbeispiel 4

Eine photopolymerisierbare Druckplatte wurde entsprechend Beispiel 2 hergestellt. An Stelle des dort eingesetzten Block-Copolymeren wurde ein handelsübliches Styrol-Isopren-Styrol-Dreiblockcopolymeres (Kraton® D 1161, Shell) gemäß DE-A 22 15 090 mit einem Styrolanteil von 15% und einem Isoprenanteil von 85% eingesetzt. Die photopolymerisierbare Druckplatte wurde wie in Beispiel 2 zum Klischee verarbeitet und beurteilt. Weiterhin wurde ein Druckversuch wie in Beispiel 2 beschrieben durchgefuhrt. Die Ergebnisse finden sich in Tabelle 2 und 3.

### Messergebnisse:

**Tabelle 2:**

| Quellverhalten und Eigenschaften der Druckplatten mit radikalisch oder kationisch polymerisierender UV-Druckfarbe | | | |
|---|---|---|---|
| | **Beispiel 2** | **Beispiel 3** | **Vergleichs- beispiel 4 (V4)** |
| notwendige Belichtungszeit [Minuten] | 14 | 8 | 16 |
| Härte nach Shore A | 85 | 82 | 62 |
| 24 h-Quellwert in radikalisch polymerisierbarer Farbe (Gewichtszunahme in %) | 0,35 | 0,42 | 1,3 |
| 24 h-Quellwert in kationisch polymerisierbarer Farbe (Gewichtszunahme in %) | 0,89 | 0,94 | 2,8 |
| Schichtdickenzunahme [µm] radikalisch polym. Farbe | 2-6 | 2-6 | 8-9 |
| Schichtdickenzunahme [µm] kationisch polym. Farbe | 15 - 25 | 15 - 25 | 30 - 50 |
| Härteverlust [Shore A] | 1-2 | 1 - 2 | 3 - 4 |
| Härteverlust [Shore A] | 2-4 | 2-4 | 4-5 |

**Tabelle 3:**

| Zunahme des Tonwertes beim Druck auf PET-Folie und auf Karton. | | | | |
|---|---|---|---|---|
| Tonwert Film [%] | Tonwert im Druck [%] | | | |
| | Platte Beispiel 2 Druck auf PET-Folie | Platte V 4 Druck auf PET-Folie | Platte Beispiel 2 Druck auf Karton | Platte V 4 Druck auf Karton |
| 100 | 100 | 100 | 100 | 100 |
| 90 | 96 | 99 | 97 | 99 |
| 80 | 94 | 97 | 98 | 98 |
| 70 | 89 | 92 | 92 | 93 |
| 60 | 80 | 87 | 83 | 87 |
| 50 | 73 | 82 | 78 | 83 |
| 40 | 61 | 75 | 70 | 80 |
| 30 | 54 | 64 | 63 | 68 |
| 20 | 41 | 48 | 52 | 55 |
| 10 | 22 | 26 | 29 | 35 |
| 5 | 9 | 16 | 20 | 22 |
| 4 | 7 | 14 | 9 | 16 |
| 2 | 5 | 11 | 10 | 12 |

Tabelle 2 zeigt, daß sich die erfindungsgemäßen Aufzeichnungmaterialien durch eine kurze Belichtungszeit (das bedeutet ein hohes Auflösungsvermögen), eine für Flexoplatten typische Härte und niedrige Quellwerte auszeichnen.

Die deutlich verbesserte Quellbeständigkeit zeigt sich auch im Druckversuch mit der kationisch härtenden Druckfarbe: Während die erfindungsgemäßen Druckplatten über eine Dauer von 4 Stunden ein hervorragendes, gleichmässiges Druckergebnis lieferten, änderte sich das Druckbild der Vergleichsplatte aus Vergleichsbeispiel 4 bereits nach 30 Min Druckdauer.

Weitere Vorteile der erfindungsgemäßen Aufzeichnungsmaterialien sind in Tabelle 3 dargestellt: Die Differenz zwischen den Tonwerten des Negativ-Films und den Drucken auf Folie (F) bzw. Karton (K) bei der erfindungsgemäßen Platte ist deutlich kleiner als im Falle des Vergleichsbeispieles. Besonders markant ist die kleine Differenz beim Bedrucken von Folie.

## Patentansprüche

1. Photopolymerisierbares Gemisch, das
(a) ein elastomeres Block-Copolymeres A als Bindemittel,
(b) eine polymerisierbare Verbindung M und
(c) eine Verbindung C enthält, die unter Einwirkung aktinischer Strahlung die Polymerisation der Verbindung M zu initiieren vermag,
**dadurch gekennzeichnet,**
**dass** das elastomere Block-Copolymere aus
einem Block (S) aus Styrol,
einem statistischen Block (S/B) aus Styrol und Butadien und
einem Block (S) aus Styrol besteht,
wobei die Glasübergangstemperatur T_{g} der Blöcke S über 25°C und die des Blockes S/B unter 25°C liegt und das Phasenvolumenverhältnis der Blöcke S zu Block S/B so gewählt ist, dass der Anteil der Hartphase S am gesamten Blockcopolymerisat 1 bis 40 Vol. % und der Gewichtsanteil des Butadiens weniger als 50 Gew. % beträgt.

2. Photopolymerisierbares Gemisch gemäß Anspruch 1, **dadurch gekennzeichnet, dass** der relative Anteil an 1,2-Verknüpfungen des Butadiens in der Polymerkette, bezogen auf die Summe an 1,2- und 1,4-cis/trans-Verknupfungen, weniger als 15% beträgt.

3. Photopolymerisierbare Druckform mit einem dimensionsstabilen Schichtträger und einer darauf aufgebrachten photopolymerisierbaren Schicht, **dadurch gekennzeichnet, dass** die photopolymerisierbare Schicht
(a) ein elastomeres Block-Copolymeres A als Bindemittel
(b) eine polymerisierbare Verbindung M und
(c) eine Verbindung C enthält, die unter Einwirkung aktinischer Strahlung die Polymerisation der Verbindung B zu initiieren vermag,
**dadurch gekennzeichnet,**
**dass** das elastomere Block-Copolymere aus
einem Block (S) aus Styrol,
einem statistischen Block (S/B) aus Styrol und Butadien und
einem Block (S) aus Styrol besteht,
wobei die Glasübergangstemperatur T_{g} der Blöcke S über 25°C und die des Blockes S/B unter 25°C liegt und das Phasenvolumenverhältnis der Blöcke S zu Block S/B so gewählt ist, dass der Anteil der Hartphase S am gesamten Blockcopolymerisat 1 bis 40 Vol. % und der Gewichtsanteil des Butadiens weniger als 50 Gew. % beträgt.

4. Photopolymerisierbare Druckform gemäß Anspruch 3 , **dadurch gekennzeichnet, dass** sie auf der photoempfindlichen Schicht eine IR-ablatierbare Schicht mit einer hohen Absorption im Wellenlängenbereicht zwischen 750 und 20000 nm und einer optischen Dichte im aktinischen Bereich von mindestens 2,5 trägt.

5. Photopolymerisierbare Druckform gemäß Anspruch 3 oder 4, **dadurch gekennzeichnet, dass** sich auf der obersten Schicht eine abziehbare Deckfolie befindet.

6. Photopolymerisierbare Druckform gemäß Ansprüchen 3 bis 5, **dadurch gekennzeichnet, dass** die photopolymerisierbare Schicht 50 - 95 Gew. % Bindemittel A, 4,9 bis 45 Gew.% polymerisierbare Verbindung M und 0,1 bis 5 Gew.% Photoinitiatoren C, jeweils bezogen auf die Summe aller Bestandteile enthält.

7. Verfahren zum Herstellen von Reliefdruckformen, **dadurch gekennzeichnet, dass** man eine photopolymerisierbare Druckform gemäß einem der Ansprüche 3, 5 oder 6 nach Abziehen der Deckfolie mit einer Filmmaske bedeckt, bildmäßig mit aktinischem Licht bestrahlt und nach Belichtung durch Auswaschen der unbelichteten Schichtbereiche mit einem Entwickler entwickelt.

8. Verfahren zum Herstellen von Reliefdruckformen, **dadurch gekennzeichnet, dass** man nach Abziehen der Deckfolie die gegen IR-Stahlung empfindliche Schicht einer photopolymerisierbaren Druckform nach Anspruch 4 oder 5 mit einem IR-Laser bildmäßig strukturiert und so eine Maske auf der darunterliegenden photopolymerisierbaren Schicht erzeugt, anschließend bildmäßig mit aktinischem Licht bestrahlt und nach Belichtung durch Auswaschen der unbelichteten Schichtbereiche mit einem Entwickler entwickelt.

9. Verwendung einer flexographischen Reliefdruckform, hergestellt nach Anspruch 7 oder 8 zum Drucken mit einer UV-härtbaren Druckfarbe.

## Claims

1. A photopolymerizable mixture which comprises
(a) an elastomeric block copolymer A as binder,
(b) a polymerizable compound M, and
(c) a compound C which on exposure to actinic radiation is able to initiate the polymerization of the compound M,
wherein
the elastomeric block copolymer consists of
a block (S) of styrene,
a random block (S/B) of styrene and butadiene, and
a block (S) of styrene,
the glass transition temperature T_{g} of the blocks S being more than 25°C and that of the block S/B being less than 25°C and the phase volume ratio of the blocks S to the block S/B being chosen such that the hard phase S makes up from 1 to 40% by volume of the overall block copolymer and the weight fraction of the butadiene is less than 50% by weight.

2. A photopolymerizable mixture as claimed in claim 1, wherein the relative amount of 1,2 linkages of the butadiene in the polymer chain, based on the sum of 1,2- and 1,4-cis/trans linkages, is less than 15%.

3. A photopolymerizable printing plate having a dimensionally stable layer support and, applied thereon, a photopolymerizable layer which comprises
(a) an elastomeric block copolymer A as binder,
(b) a polymerizable compound M, and
(c) a compound C which on exposure to actinic radiation is able to initiate the polymerization of the compound M,
wherein
the elastomeric block copolymer consists of
a block (S) of styrene,
a random block (S/B) of styrene and butadiene, and
a block (S) of styrene,
the glass transition temperature Tg of the blocks S being more than 25°C and that of the block S/B being less than 25°C and the phase volume ratio of the blocks S to the block S/B being chosen such that the hard phase S makes up from 1 to 40% by volume of the overall block copolymer and the weight fraction of the butadiene is less than 50% by weight.

4. A photopolymerizable printing plate as claimed in claim 3, which carries on the photosensitive layer an IR-ablatable layer having high absorption in the wavelength range between 750 and 20,000 nm and an optical density in the actinic range of at least 2.5.

5. A photopolymerizable printing plate as claimed in claim 3 or 4, wherein a removable cover sheet is positioned on the topmost layer.

6. A photopolymerizable printing plate as claimed in any of claims 3 to 5, wherein the photopolymerizable layer comprises 50 - 95% by weight of binder A, 4.9 - 45% by weight of polymerizable compound M, and 0.1 - 5% by weight of photoinitiators C, based in each case on the sum of all constituents.

7. A process for producing a relief printing plate, which comprises removing the cover sheet from a photopolymerizable printing plate as claimed in any of claims 3, 5 and 6 and then covering said plate with a film mask, subjecting it to imagewise irradiation with actinic light, and, following exposure, developing it with a developer by washing out the unexposed areas of the layer.

8. A process for producing a relief printing plate, which comprises removing the cover sheet from the IR-sensitive layer of a photopolymerizable printing plate as claimed in claim 4 or 5 and then subjecting it to imagewise structuring with an IR laser so as to produce a mask on the underlying photopolymerizable layer, then subjecting it to imagewise irradiation with actinic light and, following exposure, developing it with a developer by washing out the unexposed areas of the layer.

9. The use of a flexographic relief printing plate prepared as claimed in claim 7 or 8 for printing with a UV-curable printing ink.

## Revendications

1. Mélange photopolymérisable, qui contient
(a) un copolymère séquencé élastomère A en tant que liant,
(b) un composé polymérisable M et
(c) un composé C, qui sous l'effet d'un rayonnement actinique peut amorcer la polymérisation du composé M,
**caractérisé en ce que**,
le copolymère séquencé élastomère est constitué d'une séquence (S) de styrène,
d'une séquence statistique (S/B) de styrène et de butadiène et d'une séquence (S) de styrène,
dans lequel la température de transition vitreuse Tg des séquences S est supérieure à 25°C et celle de la séquence S/B est inférieure à 25°C et le rapport volumique de phase des séquences S à la séquence S/B est choisi de telle sorte que la proportion de la phase dure S par rapport au copolymère séquencé total est de 1 à 40% en volume et la proportion pondérale du butadiène est inférieure à 50% en poids.

2. Mélange photopolymérisable selon la revendication 1, **caractérisé en ce que** la proportion relative des liaisons 1,2 du butadiène dans la chaîne polymère, par rapport à la somme des liaisons 1,2- et 1,4-cis/trans, est inférieure à 15%.

3. Forme d'impression photopolymérisable ayant un support de couche aux dimensions stables et une couche photopolymérisable appliquée dessus, **caractérisées en ce que** la couche photopolymérisable contient
(a) un copolymère séquencé élastomère A an tant que liant
(b) un composé polymérisable M et
(c) un composé C qui sous l'effet d'un rayonnement actinique peut amorcer la polymérisation du composé M,
**caractérisé en ce que**,
le copolymère séquencé élastomère est constitué d'une séquence (S) de styrène,
d'une séquence statistique (S/B) de styrène et de butadiène et
d'une séquence (S) de styrène,
dans laquelle la température de transition vitreuse T_{g} des séquences S est supérieure à 25° et celle de la séquence S/B est inférieure à 25° et le rapport volumique de phase des séquences S à la séquence S/B est choisi de telle sorte que la proportion de la phase dure S par rapport au copolymère séquencé total est de 1 à 40% en volume et la proportion pondérale du butadiène est inférieure à 50% en poids.

4. Forme d'impression photopolymérisable selon la revendication 3, **caractérisée en ce qu'**elle porte sur la couche photosensible, une couche pouvant s'ablater par exposition aux IR, avec une absorption élevée dans la plage de longueurs d'onde entre 750 et 20 000 nm et une densité optique d'au moins 2,5 dans la plage actinique.

5. Forme d'impression photopolymérisable selon la revendication 3 ou 4, **caractérisée en ce que**, une feuille de recouvrement amovible se trouve sur la couche supérieure.

6. Forme d'impression photopolymérisable selon les revendications 3 à 5, **caractérisée en ce que** la couche photopolymérisable contient 50 à 95% en poids de liant A, 4,9 à 45% en poids de composé polymérisable M et 0,1 à 5% en poids de photoamorceur C, respectivement par rapport à la somme de tous les composants.

7. Procédé de préparation de formes d'impression en relief, **caractérisé en ce que** l'on couvre une forme d'impression photopolymérisable selon l'une quelconque des revendications 3, 5 ou 6, d'un masque de film après avoir retiré la feuille de recouvrement, on l'irradie avec de la lumière actinique en formant une image et après exposition, on développe avec un révélateur en éliminant par lavage les zones de couche non exposées.

8. Procédé de préparation de formes d'impression en relief, **caractérisé en ce qu'**après avoir enlevé la feuille de recouvrement, l'on structure la couche sensible au rayonnement IR d'une forme d'impression photopolymérisable selon la revendication 4 ou 5 avec un laser IR en formant une image et en produisant ainsi un masque sur la couche photopolymérisable sous-jacente, ensuite on l'irradie en formant une image avec une lumière actinique et après exposition, on développe avec un révélateur en éliminant les zones non exposées par lavage.

9. Utilisation d'une forme d'impression en relief flexographique, préparée selon la revendication 7 ou 8 pour imprimer avec une encre d'impression durcissable aux UV.
